# EUROPEAN PATENT APPLICATION

(11) **EP 1 829 987 A2**
(43) Date of publication of application: **05.09.2007**
(21) Application number: 07004489.6
(22) Date of filing: 05.03.2007
(51) Int. Cl.: C23C 22/06, C23F 11/12, C23F 11/14, C23F 11/173

(54) **Surface treating agent and method for manufacturing coating using the same**

(30) Priority: 03.03.2006 JP 2006058108
(71) Applicant: MEC COMPANY LTD., Amagasaki-shi, Hyogo 660-0832 (JP)
(72) Inventor: Furukawa, Yoshiaki, Amagasaki-shi Hyogo 660-0832 (JP); Yaguma, Noriko, Amagasaki-shi Hyogo 660-0832 (JP); Nishie, Kenji, Amagasaki-shi Hyogo 660-0832 (JP)
(74) Representative: Schwarzensteiner, Marie-Luise

(57) **Abstract**

A surface treating agent for copper or copper alloy is provided, including an imidazole compound and sugar alcohol. According to the surface treating agent, copper ions dissolving into the surface treating agent combine with the sugar alcohol, and therefore the formation of a coating on a dissimilar metal can be suppressed. Further, since the sugar alcohol is used, a treating process of its liquid waste will become easy and a load on environment can be reduced.

## Description

The present invention relates to a surface treating agent for copper or copper alloy and a method for manufacturing a coating using the same.

Conventionally, as a surface treating agent that is for forming a coating in order to prevent rust and improve the solderability of a circuit wiring made of copper or copper alloy (hereinafter they may be simply called "copper"), Organic Solderability Preservative (a water soluble preflux) containing an imidazole compound such as benzimidazole is known (see for example JP H07(1995)-54169 A, JP H05(1993)-237688 A, JP H05(1993)-163585 A and JP H11(1999)-177218 A).

Meanwhile, there is a case where a metal other than copper, such as gold, silver, aluminum, tin and solder (hereinafter they may be called "dissimilar metal") may coexist on a copper wiring of a print wiring board. When such a board with a dissimilar metal coexisting thereon is treated with a water soluble preflux containing an imidazole compound as stated above, a coating will be formed over the dissimilar metal as well, which may cause a problem such as discoloration.

Conceivably, the reasons for the formation of a coating on the dissimilar metal follow. During the above-stated treatment with a water soluble preflux, copper ions dissolving into the water soluble preflux from the copper surface adhere to the dissimilar metal in the form of oxides and hydroxides, and the copper adhering to the dissimilar metal combines with the imidazole compound, thus forming the coating.

In order to cope with the above-stated problem, a technology has been proposed, in which copper ions dissolving from a board into a surface treating agent are made chelate, so as to prevent the adhesion of the copper ions to a dissimilar metal (see for example, JP S52(1977)-72342 A, JP H06(1994)-81161 A and JP H09(1997)-291372 A).

According to the methods described in JP S52(1977)-72342 A, JP H06(1994)-81161 A and JP H09(1997)-291372 A, however, a chelating agent is used, which is accompanied by a complicated treating process of its liquid waste, and therefore a load on environment might be increased. Furthermore, the chelating agents described in the above-stated patent documents will impede the formation of a coating on copper, and therefore the methods described in the above-stated patent documents may degrade the solderability.

Therefore, with the foregoing in mind, it is an object of the present invention to provide a surface treating agent that is capable of suppressing the formation of a coating on a dissimilar metal without impeding the formation of a coating on copper, as well as capable of reducing a load on environment, and to provide a method for manufacturing a coating using the same.

A surface treating agent of the present invention is a surface treating agent for copper or copper alloy, and includes an imidazole compound and sugar alcohol.

A method for forming a coating of the present invention includes the step of bringing a surface of a board on which copper or copper alloy coexists with a metal other than copper into contact with a surface treating agent, so as to form the coating on the copper or the copper alloy. In this method, the surface treating agent is the above-stated surface treating agent of the present invention.

These and other advantages of the present invention will become apparent to those skilled in the art upon reading and understanding the following detailed description.

A surface treating agent of the present invention is used for the purpose of forming a coating on a copper surface that forms a wiring in order to prevent rust and improve solderability. The above-stated surface treating agent contains an imidazole compound as a main component of the coating to be formed and sugar alcohol that combines copper ions dissolving into the surface treating agent. Thereby, the formation of a coating on a dissimilar metal can be suppressed, and moreover a treating process of its liquid waste will be easier than in the conventional surface treating agent using a chelating agent because the sugar alcohol is used, whereby a load on environment can be reduced. In addition, when the above-stated surface treating agent is used as a water soluble preflux, the solderability will not be degraded even after a process at a high-temperature such as reflow, so that a coating having high heat resistance can be formed.

The above-stated surface treating agent may be prepared by dissolving an imidazole compound and sugar alcohol in a solvent, for example. As the solvent, water such as ion-exchanged water, pure water or extrapure water, acid such as organic acid or inorganic acid, or aqueous organic solvent may be used, for example. Acid or aqueous organic solvent used as the solvent can promote the solubility of an imidazole compound.

The above-stated imidazole compound is not limited especially, and benzimidazole compounds such as 2-propylbenzimidazole, 2-cyclohexylbenzimidazole, 2-phenylbenzimidazole, 2-benzilbenzimidazole, 2-(3-phenylpropyl)-5-methylbenzimidazole, 2-(mercaptomethyl) benzimidazole, 2-(1-naphthylmethyl)benzimidazole, 2-(5'-phenyl)pentylbenzimidazole and 2-phenylethylbenzimidazole, and imidazole compounds such as 2,4-diphenyl-5-methylimidazole, 2-pentylimidazole, 2-undecyl-4- methylimidazole, 2,4-dimethylimidazole, 2,4-diphenylimidazole, 2,4,5-triphenylimidazole, 2-benzilimidazole and 2-benzil-4-methylimidazle may be used. The surface treating agent of the present invention may contain two types or more of these imidazole compounds.

The concentration of the imidazole compound in the above-stated surface treating agent is preferably 0.01 to 5 mass%, and more preferably 0.05 to 1 mass%. In the case of the concentration of the imidazole compound less than 0.01 mass%, there is a possibility of a failure to form a coating. On the other hand, the concentration of the imidazole compound more than 5 mass% may cause a deposition of the imidazole compound.

The above sugar alcohol also is not limited especially, and monosaccharide alcohols such as mannitol, sorbitol, xylitol, erythritol, maltitol and lactitol, disaccharide alcohols such as sucrose and polysaccharide alcohols such as oligosaccharide alcohol may be used, for example. Among them, mannitol, sorbitol and xylitol are preferable, because they are at low cost and available easily. The surface treating agent of the present invention may contain two types or more of these sugar alcohols.

The concentration of the sugar alcohol in the above-stated surface treating agent is preferably 0.01 to 7 mass%, more preferably 0.05 to 4 mass% and the most preferably 0.1 to 1 mass%. In the case of the concentration of the sugar alcohol less than 0.01 mass%, the effect of suppressing the formation of a coating on a dissimilar metal may be reduced. On the other hand, in the case of the concentration of the sugar alcohol more than 7 mass%, the effect corresponding to the excessive concentration cannot be expected, and therefore such a concentration may be uneconomical.

In the case where the surface treating agent of the present invention contains an organic acid, specific examples of the applicable organic acids include formic acid, acetic acid, propionic acid, glycolic acid, n-butyric acid, isobutyric acid, acrylic acid, crotonic acid, isocrotonic acid, oxalic acid, malonic acid, succinic acid, adipic acid, maleic acid, acetylenedicarboxylic acid, monochloroacetic acid, trichloroacetic acid, monobromoacetic acid, lactic acid, oxybutyric acid, glyceric acid, tartaric acid, malic acid, citric acid, enanthic acid, caproic acid and the mixture of two types or more of them, for example. From the cost efficiency perspective, at least one selected from formic acid and acetic acid is preferable. The concentration of the organic acid in the above-stated surface treating agent is preferably 1 to 80 mass%, more preferably 1.5 to 45 mass% and the most preferably 3 to 30 mass%. The concentration of the organic acid less than 1 mass% may cause a deposition of the imidazole compound. On the other hand, the concentration of the organic acid more than 80 mass% may lead to the difficulty to form a coating.

In the case where the surface treating agent of the present invention contains an inorganic acid, specific examples of the applicable inorganic acids include hydrochloric acid, sulfuric acid, nitric acid, phosphoric acid and the mixture of two types or more of them, for example. The concentration of the inorganic acid in the above-stated surface treating agent is preferably 1 to 80 mass%, more preferably 1.5 to 30 mass% and the most preferably 3 to 15 mass%. The concentration of the inorganic acid less than 1 mass% may cause a deposition of the imidazole compound. On the other hand, the concentration of the inorganic acid more than 80 mass% may lead to the difficulty to form a coating.

In the case where the surface treating agent of the present invention contains an aqueous organic solvent, specific examples of the applicable aqueous organic solvents include methanol, ethanol, 2-propanol, ethylene glycol monomethyl ether, ethylene glycol monoethyl ether and the like, for example. The concentration of the aqueous organic solvent in the above-stated surface treating agent is preferably 1 to 80 mass%, more preferably 1.5 to 30 mass% and the most preferably 3 to 15 mass%. The concentration of the aqueous organic solvent less than 1 mass% may cause a deposition of the imidazole compound. On the other hand, the concentration of the aqueous organic solvent more than 80 mass% may lead to the difficulty to form a coating.

The method for using the surface treating agent of the present invention is not limited especially, and it may be used by a dipping method, a spraying method and the like. Among them, the dipping method is used preferably, because the coating can be formed more uniformly. In the case where the surface treating agent is used by a dipping method, the dipping time is preferably 15 to 120 seconds from the perspective of a capability of forming a coating, and more preferably 30 to 90 seconds. A temperature at which the surface treating agent is used is preferably 10 to 45°C from the perspective of a capability of forming a coating, and more preferably 25 to 35°C. Note here that the surface treating agent of the present invention may contain an additive such as coating formation aid or a solubility stabilizer, as needed, in combination with the above exemplified components.

In the case where the surface treating agent of the present invention is used by an apparatus, after all of the above-stated components of the surface treating agent are mixed so as to have a predetermined composition, it may be supplied to the apparatus. Alternatively, the respective components may be individually supplied to the apparatus, and the respective components may be mixed in the apparatus to have a predetermined composition. When the respective components of the surface treating agent are supplied to the apparatus, the concentrations of the respective components are not limited especially. For example, the respective components of a high concentration may be supplied to the apparatus, followed by dilution with acid or water in the apparatus to have predetermined concentrations.

In some cases, a surface treating agent for forming a rust-preventive coating on copper may contain copper ions added therein in order to facilitate the formation of the coating. In the case of a print board with a dissimilar metal coexisting thereon, however, if the copper ions are added in a surface treating agent, a coating will be formed on the dissimilar metal also. Thus, it is not possible to add copper ions in that case, so that there is a possibility of the difficulty in forming a coating on the copper surface. According to the surface treating agent of the present invention, the function of the sugar alcohol prevents the degradation of a capability of forming a coating on copper even without copper ions added therein.

A method for forming a coating of the present invention is a method including the step of bringing a surface of a board with copper or copper alloy coexisting with a metal other than copper into contact with a surface treating agent, so as to form the coating on the copper or the copper alloy. In the method, the surface treating agent used is the surface treating agent of the present invention as described above. According to the coating formation method of the present invention, as described above, copper ions dissolving into the surface treating agent combine with sugar alcohol, and therefore the formation of a coating on the metal other than copper (dissimilar metal) can be suppressed without impeding the formation of the coating on copper. In particular, in the case where the dissimilar metal is gold or gold alloy, the function of the present invention can be effectively achieved. Moreover, since the method uses sugar alcohol, the treating process of its liquid waste becomes easy, and a load on environment can be reduced. Note here that a specific method for bringing the surface of the board into contact with the surface treating agent may be similar to the above-described method for using the surface treating agent of the present invention.

### Examples

The following describes examples of the surface treating agent of the present invention together with comparative examples. Note here that the present invention is not limited to the following examples.

### Experiment 1 (Evaluations of the coating amounts formed on a dissimilar metal)

Firstly, 0.1 mass% of 2-(1-naphthylmethyl)benzimidazole, 5.25 mass% of formic acid and xylitol with the concentrations shown in Table 1 were added to ion-exchanged water to prepare surface treating agents of examples 1 to 12. As comparative example 1, a surface treating agent was prepared in a similar manner to examples 1 to 12 except that xylitol was not added thereto.

Next, double-sided copper-clad laminates whose size was 4 cm x 4 cm were prepared, each composed of copper foil of 18 µm in thickness attached to both sides of a glass epoxy base (produced by Hitachi Chemical Co., Ltd., GEA-67N, thickness: 1.6 mm). Ni-plated films of 0.5 µm in thickness then were formed on the copper foils on both sides, and further gold-plated films of 0.05 µm in thickness were formed on the Ni-plated films, so as to prepare members to be treated. Following this, these members to be treated were immersed one by one in each of the surface treating agents of examples 1 to 12 and comparative example 1 for 60 seconds, followed by washing with water and drying. At this time, treatment in two ways was conducted thereto: in one case, 30 mg/L of copper acetate in terms of the copper ion concentration was added to each of the surface treating agents, and in the other case it was not added. A temperature of the surface treating agents was set at 30°C for either case. Next, the treated members after drying were immersed in a mixture solution containing 35 mass% of hydrochloric acid and methanol (their mass ratio was hydrochloric acid : methanol = 0.5 : 99.5) for 5 minutes, so as to dissolve the coating component, which attached to the gold, into the above-stated mixture solution. Then, the mixture solution in which the coating component was dissolved was sampled, and the absorbance of the absorption peak (277 nm) of 2-(1-naphthylmethyl)benzimidazole was measured for each with a UV-visible spectrophotometer. Then, assuming that the absorbance of comparative example 1 in which copper ions were not added was set at 1, the relative values of the absorbance of the other surface treating agents used were calculated, and the coating amounts on gold were evaluated based on the values. Table 1 shows the results.

**[Table 1]**

| | Concentration of xylitol (mass%) | Absorbance (relative value) | |
|---|---|---|---|
| | | Copper ions were not added | 30 mg/L of copper ions were added |
| Ex. 1 | 0.010 | 0.56 | 0.80 |
| Ex. 2 | 0.030 | 0.48 | 0.68 |
| Ex. 3 | 0.050 | 0.40 | 0.60 |
| Ex. 4 | 0.100 | 0.36 | 0.48 |
| Ex. 5 | 0.300 | 0.36 | 0.40 |
| Ex. 6 | 0.500 | 0.30 | 0.40 |
| Ex. 7 | 1.000 | 0.28 | 0.36 |
| Ex. 8 | 2.000 | 0.32 | 0.44 |
| Ex. 9 | 3.000 | 0.32 | 0.44 |
| Ex. 10 | 4.000 | 0.28 | 0.56 |
| Ex. 11 | 5.000 | 0.32 | 0.72 |
| Ex. 12 | 7.000 | 0.32 | 0.72 |
| Comp. Ex. 1 | 0.000 | 1.00 | 1.60 |

As for examples 1 to 12, defective appearance was not found, and moreover as shown in Table 1, the absorbance thereof was smaller than comparative example 1 (this means smaller coating amounts on gold), and therefore it was found that the coating formation on gold could be suppressed in these examples. In particular, in examples 3 to 10 in which the concentration of xylitol was in the range of 0.05 to 4 mass%, their appearance was good by visual observation, and even in the case of 30 mg/L of copper ions added thereto, the formation of a coating on gold could be suppressed effectively.

### Experiment 2 (Relationship between the concentration of copper ions in a surface treating agent and the coating amounts)

Firstly, 0.3 mass% of 2-methylbenzimidazole, 4.5 mass% of acetic acid and 0.5 mass% of D-sorbitol were added to ion-exchanged water, to which copper acetate was further added to so as to have the copper ion concentrations as shown in Table 2, to prepare surface treating agents of examples 13 to 20. As comparative examples, surface treating agents as comparative examples 2 to 9 were prepared in a similar manner to examples 13 to 20, respectively, except that D-sorbitol was not added thereto. Then, for each of examples 13 to 20 and comparative examples 2 to 9, a member to be treated is treated in a similar manner to the above Experiment 1, and the amount of a coating on gold was evaluated for each in a similar manner to the above Experiment 1. Table 2 shows the results.

**[Table 2]**

| | Copper ion concentration (mg/L) | absorbance(relative value) |
|---|---|---|
| Ex. 13 | 0 | 0.44 |
| Ex. 14 | 5 | 0.48 |
| Ex. 15 | 10 | 0.44 |
| Ex. 16 | 20 | 0.56 |
| Ex. 17 | 30 | 0.52 |
| Ex. 18 | 50 | 0.76 |
| Ex. 19 | 75 | 1.12 |
| Ex. 20 | 100 | 1.60 |
| Comp. Ex. 2 | 0 | 1.00 |
| Comp. Ex. 3 | 5 | 1.24 |
| Comp. Ex. 4 | 10 | 1.40 |
| Comp. Ex. 5 | 20 | 1.56 |
| Comp. Ex. 6 | 30 | 1.60 |
| Comp. Ex. 7 | 50 | 1.84 |
| Comp. Ex. 8 | 75 | 2.08 |
| Comp. Ex. 9 | 100 | 1.80 |

As shown in Table 2, as compared with the corresponding comparative examples 2 to 9, examples 13 to 20 had smaller amounts of a coating on gold even when copper ion concentrations were increased, and therefore it was found that examples 13 to 20 are able to suppress the formation of a coating on gold.

From these results, it was found that the surface treating agents of the present invention are able to suppress the formation of a coating on a dissimilar metal. Further, as shown in Table 3 concerning the results of the coating amounts on gold evaluated similarly when various imidazole compounds were used and in Table 4 concerning the results of the coating amounts on gold when various sugar alcohols were used, the surface treating agents of the present invention were able to realize such effects irrespective of the types of the imidazole compounds and the types of the sugar alcohols. Note here that, in Table 3, the absorbance was measured for each example when 30 mg/L of copper acetate in terms of copper ions was added, and the coating amounts were evaluated with reference to the samples where sugar alcohol was not added (absorbance: 1). In Table 4, the coating amounts were evaluated when the types of sugar alcohols were varied for the samples containing 0.1 mass% of 2-(5'-phenyl)pentylbenzimidazole and 4.5 mass% of acetic acid.

**[Table 3]**

| | Imidazole compounds used | Acids used | Absorbance (relative value) |
|---|---|---|---|
| Ex. 21 | 2-(1-naphthylmethyl)benzimidazole (0.3 mass%) | Formic acid(5.25 mass%) | 0.29 |
| Ex. 22 | 2-(5'-phenyl)pentylbenzimidazole (0.3 mass%) | Acetic acid (4.5 mass%) | 0.30 |
| Ex. 23 | 2,4-diphenyl-5-methylimidazole (0.3 mass%) | Acetic acid (4.5 mass%) | 0.50 |
| Ex. 24 | 2-phenylbenzimidazole (0.3 mass%) | Acetic acid (4.5 mass%) | 0.48 |

**[Table 4]**

| | Sugar alcohols used | Absorbance (relative value) | |
|---|---|---|---|
| | | Copper ions were not added | 30 mg/L of copper ions were added |
| Ex.25 | D-sorbitol (0.5 mass%) | 0.44 | 0.52 |
| Ex.26 | Xylitol (0.5 mass%) | 0.52 | 0.64 |
| Ex.27 | D-mannitol (0.5 mass%) | 0.56 | 0.60 |
| Ex. 28 | Amarutei MR20 (produced by Towa Chemical Industry Co., Ltd. disaccharide alcohol, 0.5 mass%) | 0.48 | 0.52 |
| Ex. 29 | Resisu(produced by Towa Chemical Industry Co., Ltd. disaccharide alcohol, 0.5 mass%) | 0.44 | 0.64 |
| Ex.30 | PO-10 (produced by Towa Chemical Industry Co., Ltd. polysaccharide alcohol, 0.5 mass%) | 0.40 | 0.60 |
| Ex.31 | PO-20(produced by Towa Chemical Industry Co., Ltd. polysaccharide alcohol, 0.5 mass%) | 0.44 | 0.68 |
| Ex.32 | PO-40 (produced by Towa Chemical Industry Co., Ltd. polysaccharide alcohol, 0.5 mass%) | 0.32 | 0.56 |
| Ex.33 | PO·300(produced by Towa Chemical Industry Co., Ltd. polysaccharide alcohol, 0.5 mass%) | 0.32 | 0.56 |
| Ex.34 | Amamiru (produced by Towa Chemical Industry Co., Ltd. polysaccharide alcohol, 0.5 mass%) | 0.40 | 0.60 |
| Comp. Ex. 10 | None | 1.00 | 1.60 |

### Experiment 3 (Confirmation of the improvement of solderability)

Firstly, 0.3 mass% of 2-(5'-phenyl)pentylbenzimidazole, 4.5 mass% of acetic acid and sugar alcohols indicated in Table 5 were added to ion-exchanged water to prepare surface treating agents of examples 35 to 44. As comparative example 11, a surface treating agent was prepared in a similar manner to examples 35 to 44 except that sugar alcohol was not added thereto.

Next, double-sided copper-clad laminates whose size was 7.8 cm x 4.8 cm were prepared, each composed of copper foil of 18 µm in thickness attached to both sides of a glass epoxy base (produced by Hitachi Chemical Co., Ltd., GEA-67N, thickness: 1.6 mm). Then, 160 through-holes of 0.8 mm in diameter were formed in each of the double-sided copper-clad laminates, so as to prepare members to be treated. Following this, these members to be treated were immersed in MECBRITE CB-801 (produced by MEC Co., Ltd., microetching agent) so as to etch the surface of the copper foil only by 1 µm, followed by washing with water, and then were immersed one by one in each of the surface treating agents of examples 35 to 44 and comparative example 11 for 60 seconds, followed by washing with water and drying. A temperature of the surface treating agents was set at 30°C for each case. Next, a reflow process was conducted once to four times for each of the treated members after drying. The reflow process was conducted using a circulating hot air reflow oven, and during one reflow process, heat was applied for 40 seconds at a temperature such that the surface temperature of the members reached 240 to 245°C. Following this, the treated members were subjected to a postflux treatment by spraying. As a post-flux agent, AGF-880 produced by Asahi Chemical Research Laboratory Co., Ltd., was used. After that, a flow process was conducted. During the flow process, heat was firstly applied for 80 seconds as a pre-heat process at a temperature such that the surface temperature of the treated members reached 100°C, followed by a double-wave process under a condition such that the temperature of solder was 255°C. At this time, the solder used had a mass ratio of 96.5 : 3 : 0.5 (Sn : Ag : Cu). According to the double-wave process in this experiment, the treated member was made into contact with solder for 2.5 seconds, followed by another contact for 3 seconds with an interval for 2.5 seconds therebetween. Then, a rejection rate regarding soldering was confirmed for each of the above-stated treated members. Table 5 shows the results. In Table 5, the soldering rejection rate represents the rate of through-holes generating defective soldering to the 160 through-holes. Note here that the defective soldering in this experiment refers to the case where it was confirmed by visual observation that a through-hole was not completely filled with solder.

**[Table 5]**

| | Sugar alcohols used | Soldering rejection rate(%) | | | |
|---|---|---|---|---|---|
| | | After 1^{st} reflow | After 2^{nd} reflow | After 3^{rd} reflow | After 4^{th} reflow |
| Ex. 35 | D-sorbitol (0.3 mass%) | 0 | 0 | 0 | 11 |
| Ex.36 | Xylitol (0,3 mass%) | 0 | 0 | 0 | 10 |
| Ex.37 | D-mannitol (0.3 mass%) | 0 | 0 | 2 | 6 |
| Ex.38 | Amarutei MR20 (produced by Towa Chemical Industry Co., Ltd. disaccharide alcohol, 0.3 mass%) | 0 | 0 | 5 | 8 |
| Ex.39 | Resisu (produced by Towa Chemical Industry Co., Ltd. disaccharide alcohol, 0.3 mass%) | 0 | 0 | 1 | 7 |
| Ex. 40 | PO-10 (produced by Towa Chemical Industry Co., Ltd. polysaccharide alcohol, 0.3 mass%) | 0 | 0 | 0 | 5 |
| Ex. 41 | PO-20 (produced by Towa Chemical Industry Co., Ltd. polysaccharide alcohol, 0.3 mass%) | 0 | 0 | 3 | 6 |
| Ex. 42 | PO.40 (produced by Towa Chemical Industry Co., Ltd. polysaccharide alcohol, 0.3 mass%) | 0 | 0 | 0 | 3 |
| Ex. 43 | PO-300 (produced by Towa Chemical Industry Co., Ltd. polysaccharide alcohol, 0.3 mass%) | 0 | 0 | 0 | 2 |
| Ex. 44 | Amamiru(produced by Towa Chemical Industry Co., Ltd. polysaccharide alcohol, 0.3 mass%) | 0 | 0 | 0 | 3 |
| Comp. Ex. 11 | None | 0 | 3 | 13 | 25 |

As shown in Table 5, in examples 35 to 44, the soldering rejection rate could be reduced as compared with comparative example 11. From these results, it was found that the surface treating agents of the present invention are able to form a coating having high heat resistance.

### Experiment 4 (Confirmation of the effect for improving solder wettability)

Firstly, 0.3 mass% of 2-(5'-phenyl)pentylbenzimidazole, 4.5 mass% of acetic acid and sugar alcohols indicated in Table 6 were added to ion-exchanged water to prepare surface treating agents of examples 45 to 54. As comparative example 12, a surface treating agent was prepared in a similar manner to examples 45 to 54 except that sugar alcohol was not added thereto.

Next, one-side copper-clad laminates were prepared, each composed of copper foil of 18 µm in thickness attached to one side of a glass epoxy base (produced by Hitachi Chemical Co., Ltd., GEA-67N, thickness: 1.6 mm). Then, 40 conductive patterns in a rectangular form of 0.3 mm x 8 mm were formed on each of the one-side copper clad laminate, so as to manufacture members to be treated. Following this, these members to be treated were immersed in MECBRITE CB-801 (produced by MEC Co., Ltd., microetching agent) so as to etch the surface of the copper foil only by 1 µm, followed by washing with water, and then were immersed one by one in each of the surface treating agents of examples 45 to 54 and comparative example 12 for 60 seconds, followed by washing with water and drying. A temperature of the surface treating agents was set at 30°C for each case. Thereafter, solder paste (produced by SOLDER COAT Co., Ltd., TAS650 S10/O11/M9.5) was printed at the center portion of the above-stated conductive patterns. At this time, the printed pattern was in a circular form. Each printed pattern was 0.4 mm in diameter and 100 µm in thickness. After printing, using a reflow oven similar to the above Experiment 3, heat was applied for 40 seconds at a temperature such that the surface temperatures of the treated members reached 225 to 230°C. Then, in the regions (40 points) in which the solder was expanded by the reflow process, the longest diameter was measured with a microscope, and their average value was calculated. Table 6 shows the results.

**[Table 6]**

| | Sugar alcohols used | Average value of diameter in regions where solder was expanded (mm) |
|---|---|---|
| Ex. 45 | D-sorbitol (0.3 mass%) | 2.20 |
| Ex. 46 | Xylitol (0.3 mass%) | 2.13 |
| Ex. 47 | D-mannitol (0.3 mass%) | 2.05 |
| Ex.48 | Amarutei MR20 (produced by Towa Chemical Industry Co., Ltd. disaccharide alcohol, 0.3 mass%) | 2.00 |
| Ex. 49 | Resisu (produced by Towa Chemical Industry Co., Ltd. disaccharide alcohol, 0.3 mass%) | 1.99 |
| Ex. 50 | PO-10 (produced by Towa Chemical Industry Co., Ltd. polysaccharide alcohol, 0.3 mass%) | 2.08 |
| Ex. 51 | PO-20 (produced by Towa Chemical Industry Co., Ltd. polysaccharide alcohol, 0.3 mass%) | 1.89 |
| Ex. 52 | PO-40 (produced by Towa Chemical Industry Co., Ltd. polysaccharide alcohol, 0.3 mass%) | 1.95 |
| Ex. 53 | PO-300 (produced by Towa Chemical Industry Co., Ltd. polysaccharide alcohol, 0.3 mass%) | 2.11 |
| Ex. 54 | Amamiru (produced by Towa Chemical Industry Co., Ltd. polysaccharide alcohol, 0.3 mass%) | 1.91 |
| Comp. Ex. 12 | None | 1.63 |

As shown in Table 6, in all of examples 45 to 54, the solder wettability was improved as compared with comparative example 12.

## Claims

1. A surface treating agent for copper or copper alloy, comprising an imidazole compound and sugar alcohol.

2. The surface treating agent according to claim 1, wherein a concentration of the sugar alcohol is within a range of 0.01 to 7 mass%.

3. The surface treating agent according to claim 1 or 2, wherein the sugar alcohol is at least one selected from the group consisting of mannitol, sorbitol and xylitol.

4. The surface treating agent according to claim 1, further comprising at least one selected from the group consisting of an inorganic acid and an organic acid.

5. The surface treating agent according to claim 4, wherein a concentration of the at least one selected from the group consisting of an inorganic acid and an organic acid is 1 to 80 mass%.

6. The surface treating agent according to claim 4 or 5, wherein the organic acid is at least one selected from the group consisting of formic acid and acetic acid.

7. A method for forming a coating, comprising the step of bringing a surface of a board on which copper or copper alloy coexists with a metal other than copper into contact with a surface treating agent, so as to form the coating on the copper or the copper alloy,
wherein the surface treating agent is the surface treating agent according to any one of claims 1 to 6.

8. The method for forming a coating according to claim 7, wherein the metal other than copper is gold or gold alloy

9. The method for forming a coating according to claim 7, wherein the surface of the board is brought into contact with the surface treating agent by immersing the surface of the board in the surface treating agent.

10. The method for forming a coating according to claim 9, wherein a time for the immersing is 15 to 120 seconds, and a temperature of the surface treating agent for the immersing is 10 to 45°C.
